(19) Europäisches Patentamt
European Patent Office
Office européen des brevets

(11) Veröffentlichungsnummer: **0 113 313**
**B1**

(12) **EUROPÄISCHE PATENTSCHRIFT**

(45) Veröffentlichungstag der Patentschrift: **15.07.87**

(51) Int. Cl.⁴: **G 03 F 7/10,** C 08 F 279/02 // (C08F279/02, 222:40)

(21) Anmeldenummer: **83810501.3**

(22) Anmeldetag: **31.10.83**

(54) **In Gegenwart von Sensibilisatoren unter Lichteinwirkung vernetzbare Stoffgemische und deren Verwendung.**

(30) Priorität: **04.11.82 CH 6416/82**

(43) Veröffentlichungstag der Anmeldung: **11.07.84 Patentblatt 84/28**

(45) Bekanntmachung des Hinweises auf die Patenterteilung: **15.07.87 Patentblatt 87/29**

(84) Benannte Vertragsstaaten: **BE CH DE FR GB LI NL**

(56) Entgegenhaltungen:
**EP - A - 0 001 597**
**EP - A - 0 002 182**

(73) Patentinhaber: **CIBA-GEIGY AG, Klybeckstrasse 141, CH-4002 Basel (CH)**

(72) Erfinder: **Berger, Joseph, Dr., Sperrstrasse 40/18, CH-4057 Basel (CH)**
Erfinder: **Lohse, Friedrich, Prof. Dr., Buchenstrasse 23, CH-4104 Oberwil (CH)**

**EP 0 113 313 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft neue, in Gegenwart von Sensibilisatoren unter Lichteinwirkung vernetzbare Stoffgemische und deren Verwendung.

Es ist bekannt, dass man Polymere mit C=C-Doppelbindungen in Gegenwart von Sensibilisatoren und/oder Vernetzungsmitteln, z.B. Gemische aus Dien(co)polymeren und Michlers Keton, Thioxanthonen oder Anthrachinon und/oder Bisimiden oder Aziden und gegebenenfalls weiteren Zusätzen unter Lichteinwirkung vernetzen und beispielsweise als sogenannte Photoresists verwenden kann [vgl. z.B. U.S. Patentschriften 3 169 868 und 3 622 321 sowie deutsche Offenlegungsschrift 3 014 261]. Werden mindestens teilweise ungesättigte Dien- oder Olefin(co)polymere radikalisch in Gegenwart von Initiatoren oder photochemisch in Gegenwart von Sensibilisatoren mit ungesättigten Carbonsäureanhydriden, wie Maleinsäureanhydriden, umgesetzt, so kommt es gleichzeitig zu Additions- (Propf-) und Vernetzungsreaktionen [vgl. z.B. japanische Offenlegungsschriften 52-96694 und 55-98204]. Die EP-A 0 001 597 und EP-A 0 002 182 beschreiben zwar Bisimide, welche jedoch zwingend Azidgruppen enthalten.

Gegenstand der Erfindung sind neue, in Gegenwart von Sensibilisatoren unter Lichteinwirkung vernetzbare Stoffgemische, enthaltend

A) ein aliphatisch ungesättigtes Polymerisationsprodukt, das durch Homo- oder Copolymerisation von Dienen, wie Butadien, Isopren, Chloropren oder Gemischen davon, gegebenenfalls in Mischung mit anderen ethylenisch ungesättigten Monomeren, die frei von aromatischen Gruppen sind und gegebenenfalls Strukturelemente der Formel I

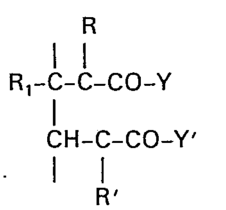

(I)

aufweisen, und

B) ein Bisimid der Formel II

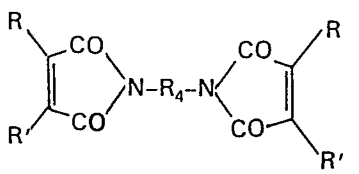

(II)

worin R und R′ unabhängig voneinander $C_{1-4}$-Alkyl oder zusammen gegebenenfalls durch eine Methylgruppe substituiertes Tetramethylen oder eine Gruppierung der Formel III

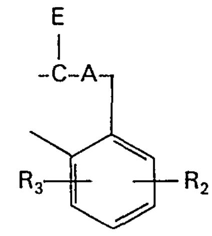

(III)

$R_1$ Wasserstoff, Chlor oder Methyl,

$R_2$ und $R_3$ unabhängig voneinander Wasserstoff, Halogen, $C_{1-4}$-Alkyl oder Methoxy,

A $-CH_2-$, $-CH_2CH_2-$ oder $-OCH_2-$ mit an den aromatischen Ring gebundenen Sauerstoff und E Wasserstoff oder A -O- und E $-CH_3$,

$R_4$ $-C_mH_{2m}-$ mit m = 1 bis 20, $-(CH_2)_xQ(CH_2)_{x'}-$, $-(CH_2)_2NH(CH_2)_2NH(CH_2)_2-$, $-CH_2-Z-CH_2-$, Phenylen, das durch ein oder zwei Chloratome oder eine oder zwei Methylgruppen substituiert sein kann, Naphthylen, eine Gruppe

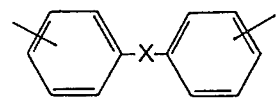

oder

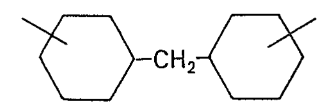

Q -S-, -O- oder insbesondere -NH-,

x und x′ unabhängig voneinander eine Zahl von 2 bis 4, bevorzugt je die Zahl 2,

Z Phenylen oder $C_{4-6}$-Cycloalkylen,

X die direkte Bindung, -O-, -S-, $-SO_2-$, $-CH_2-$ oder $-C(CH_3)_2-$ und Y und Y′ je -OH oder zusammen -O- darstellen, wobei der Anteil an Bisimid der Formel II 0,1 bis 75 Gew.%, bevorzugt 1 bis 25 Gew.%, bezogen auf das Polymer A), beträgt.

Durch R, R′, $R_2$ und $R_3$ dargestellte Alkylgruppen können geradkettig oder verzweigt sein. Als Beispiele solcher Gruppen seien genannt: Methyl, Äthyl, n-Propyl, Isopropyl, n-Butyl und sek-Butyl. Bevorzugt sind Alkylgruppen mit 1 oder 2 C-Atomen, vor allem Methyl.

Stellen R und R′ zusammen eine Gruppierung der Formel III dar, so bedeuten E, $R_2$ und $R_3$ vorzugsweise Wasserstoff und A ist $-CH_2-$. Bevorzugt stellen R und R′ zusammen Tetramethylen, 3- oder 4-Methyltetramethylen und vor allem je Methyl dar.

Stellt $R_4$ $-C_mH_{2m}-$ dar, so kann es sich um geradkettige oder verzweigte Reste handeln, wie z.B. Methylen, Äthylen, 1,2- oder 1,3-Propylen, Tetramethylen, 1,1,3,3-Tetramethylbutylen, Pentamethylen, Hexamethylen, Heptamethylen, Octamethylen, Nonamethylen, Decamethylen, Undecamethylen, Tridecamethylen, Tetradecamethylen, Hexadecamethylen, Heptadecamethylen, Octadecamethylen und Eisocylen. Bevorzugt sind geradkettige Reste $-C_mH_{2m}-$ mit m = 2–10. Bedeutet $R_4$ eine Gruppe $-CH_2-Z-CH_2$, so handelt es sich z.B. um die 1,3- oder 1,4-Phenylengruppe, 1,2-Cyclobutylen-, 1,3-Cyclopentylen- oder 1,3-Cyclohexylengruppe. Bevorzugt stellt Z 1,3-oder 1,4-Phenylen, 1,3- oder 1,4-Cyclohexylen dar.

Bedeutet $R_4$ Phenylen, das durch ein oder zwei Chloratome oder eine oder zwei Methylgruppen substituiert sein kann, so kommen z.B. die 1,3- und 1,4-Phenylen, o- oder m-Toluylen-, 4,5-Dimethyl-1,2-phenylen- und 3-Chlor-1,4-phenylengruppe in Betracht. Stellt $R_4$ eine Gruppe

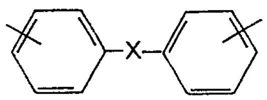

oder

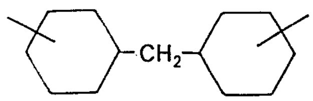

dar, so handelt es sich vor allem um den Rest des 4,4'-Diaminodicyclohexylmethans, 4,4'-Diaminodiphenylmethans, 4,4'-Diaminodiphenyläthers oder 4,4'-Diaminodiphenylsulfids. $R_4$ stellt vorzugsweise geradkettiges $-C_mH_{2m}-$ mit m = 2–10, $-(CH_2)_2Q(CH_2)_2-$ mit Q = -S-, -O- und insbesondere -NH-, $-CH_2-Z-CH_2-$ mit Z = 1,3- oder 1,4-Phenylen, 1,3- oder 1,4-Cyclohexylen; den Rest des 4,4'-Diaminodiphenylmethans, 4,4'-Diaminodiphenyläthers oder 4,4'-Diaminodiphenylsulfids, 1,3- oder 1,4-Phenylen dar.

Y und Y' bilden vorzugsweise zusammen -O-.

Ganz besonders bevorzugt sind Stoffgemische, worin R und R' je Methyl, Y und Y' zusammen -O- und $R_4$ $-(CH_2)_2NH(CH_2)_2-$ und vor allem geradkettiges $-C_2H_{2m}-$ mit m = 2–10 bedeuten.

Die erfindungsgemäss einzusetzenden Polymeren weisen vorzugsweise ein durchschnittliches Molekulargewicht von 1000 bis 1 000 000 und ganz besonders von 1000 bis 350 000 auf. Das durchschnittliche Molekulargewicht der Polymeren kann nach an sich bekannten Methoden, z.B. mittels Lichtstreuung, Dampfdruckosmometrie oder Ultrazentrifugation, bestimmt werden.

Geeignete Polymerisationsprodukte sind z.B. Polymere, die durch Homo- oder Copolymerisation von Dienen, wie z.B. Butadien, Isopren, Chloropren oder Gemischen davon, gegebenenfalls zusammen mit anderen äthylenisch ungesättigten Monomeren, die frei von aromatischen Gruppen sind, erhalten werden. Beispiele von derartigen Monomeren sind Acrylsäure, Methacrylsäure, Acrylsäure- und Methacrylsäureester, Acrylnitril, Vinylacetat und dessen Verseifungsprodukte, Vinylchlorid, Vinylidenchlorid und -fluorid oder Maleinsäureanhydrid.

Bevorzugt verwendet man Polymere, die aus wiederkehrenden Strukturelementen der Formeln IV oder V

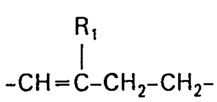 (IV) oder 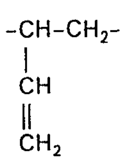 (V)

bestehen, wobei $R_1$ die unter Formel I angegebene Bedeutung hat. Besonders bevorzugt sind 1,2-Polybutadien und vor allem 1,4-Polybutadien.

Polymere, die Strukturelemente der Formel I aufweisen, können dadurch erhalten werden, dass man aliphatisch ungesättigte Polymere, die frei von aromatischen Gruppen sind, radikalisch oder unter Lichteinwirkung mit einer Verbindung der Formel VI

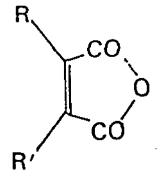 (VI)

umsetzt und gegebenenfalls die Anhydridgruppen hydrolysiert, wobei R und R' die unter Formel I angegebene Bedeutung haben. Die Umsetzung wird zweckmässig in Inertgasatmosphäre, z.B. unter Stickstoff, und in Gegenwart eines inerten organischen Lösungsmittels und eines Sensibilisators der untenstehend beschriebenen Art durchgeführt. Als Lösungsmittel eignen sich z.B. aliphatische, cycloaliphatische oder aromatische, gegebenenfalls halogenierte Kohlenwasserstoffe, wie Pentan, Hexan, Heptan, Cyclohexan, Benzol, Toluol, Chlorbenzol, Dichlorbenzole; cyclische oder aliphatische Amide, wie N-Methylpyrrolidon, N-Äthyl-2-pyrrolidon, N-Methyl-ε-caprolactam, N,N-Dimethylformamid, N,N-Dimethylacetamid und N,N-Diäthylacetamid; aliphatische und cyclische Ketone, wie Aceton, Methyläthylketon, Cyclohexanon und Cyclopentanon; Alkohole, wie Methanol, Äthanol und 2-Methoxyäthanol. Es können auch Gemische der genannten Lösungsmittel verwendet werden. Bevorzugte Lösungsmittel sind gegebenenfalls halogenierte aromatische Kohlenwasserstoffe, besonders Benzol, Toluol und Chlorbenzol oder Gemische davon.

Die Verbindungen der Formeln IV, V und VI sind bekannt oder können nach an sich bekannten Methoden hergestellt werden. Verbindungen der Formel II können auf an sich bekannte Weise durch Umsetzung einer Verbindung der Formel VI mit Diaminen $H_2N-R_4-NH_2$ und Cyclisierung der intermediär entstehenden Amidsäuren erhalten werden.

Die erfindungsgemässen Stoffgemische können neben dem Sensibilisator weitere übliche Zusätze enthalten, z.B. weitere Vernetzungsmittel. Als zusätzliche Vernetzungsmittel kommen insbesondere Diamine, z.B. solche der in der deutschen Offenlegungsschrift 2 657 104 beschriebenen Art, in Betracht. Als Sensibilisatoren eignen sich insbesondere Triplettsensibilisatoren, bei deren Anwendung die Reaktion durch Triplettenergietransfer des angeregten Sensibilisators auf die nicht angeregten Verbindungen der Formel II erfolgt, wie z.B. Ketone, beispielsweise Acetophenon, Benzophenon, Aceton, Methyläthylketon, Methylisobutylketon, Michlers Keton, 1,2-Dibenzilbenzol, 1,4-Diacetylbenzol, 4-Cyanobenzophenon, Thioxanthone, Anthrachinon, 1,2-und 1,4-Naphthochinon, 2-Methylanthrachinon, Benzanthron, Violantron, p,p'-Tetramethyldiaminobenzophenon, Chloranil; Anthracen, Chrysen; Nitroverbindungen, wie Nitrobenzol, p-Dinitrobenzol, 1- oder 2-Nitronaphthalin, 2-Nitrofluoren, 5-Nitroacenaphthen, Nitroanilin, 2-Chlor-4-nitroanilin, 2,6-Dichlor-4-nitroanilin. Als Sensibilisatoren können auch Radikal-Initiatoren, wie Azoisobutyronitril oder Peroxide, z.B. Dibenzoylperoxid, eingesetzt werden. Bevorzugt verwendet man als Sensibilisatoren unsubstituierte oder substituierte Thioxanthone, z.B. solche der in den deutschen Offenlegungsschriften 3 018 891 und 3 117 568 sowie der europäischen Patentanmeldung Veröffentl. Nr. 33 720 beschriebenen Art.

Gegenstand der Erfindung sind auch die vernetzten Produkte, die dadurch erhältlich sind, dass man ein definitionsgemässes Stoffgemisch, in Gegenwart eines Sensibilisators und gegebenenfalls in Gegenwart eines weiteren Vernetzungsmittels unter Lichteinwirkung vernetzt. Als Sensibilisatoren kommen z.B. solche der oben erwähnten Art in Betracht.

Für die Belichtung bei den Vernetzungsreaktionen wie auch bei der allfälligen vorausgehenden Umsetzung der Polymeren mit den Anhydriden der Formel VI wird vorzugsweise UV-Licht verwendet. Als Lichtquellen eignen sich z.B. Xenonlampen, Kohlelichtbögen, Quecksilberlampen und Metallhalogenid-Quecksilberlampen.

Die erfindungsgemässen Stoffgemische eignen sich z.B. zur Herstellung von Beschichtungen und Überzügen auf verschiedenen Substraten, z.B. Metallen, wie Aluminium, Kupfer und Stahl, oder Kunststoffen, wie Polyestern, Celluloseacetat und dergleichen, oder zur Herstellung von Druckplatten für das Offsetdruckverfahren, zur Herstellung von Photooffset-Lacken, für die unkonventionelle Photographie, z.B. zur Herstellung von photographischen Bildern mittels Photovernetzung. Bevorzugt werden sie zur Herstellung von Druckplatten oder als sogenannte Photoresistmaterialien zur Herstellung von gedruckten Schaltungen nach an sich bekannten Methoden verwendet. Bei der letzteren Anwendung wird die mit der lichtempfindlichen Schicht versehene Seite der Leiterplatte durch eine das Leiterbild aufweisende Photomaske belichtet und dann entwickelt, worauf man die unbelichteten Stellen der Schicht durch Entwicklungsflüssigkeit herausholt. Die Trägermaterialien können nach an sich üblichen Techniken mit den lichtempfindlichen Stoffgemischen beschichtet werden, z.B. durch Tauchverfahren, Sprüh-, Schleuder-, Kaskaden-, Rakel- oder Vorhangguss oder sogenanntes «roller-coating».

Die erfindungsgemässen Stoffgemische zeichnen sich vor allem durch ihre hohe Lichtempfindlichkeit aus. Die damit erhältlichen vernetzten Produkte, bevorzugt in Form von Beschichtungen, weisen ein gutes photographisches Auflösungsvermögen, eine hohe Elastizität und eine ausgezeichnete Haftung auf verschiedenen Substraten, z.B. solchen der vorerwähnten Art, auf. Beschichtungen, die aus einem Bisimid der Formel II und einem Polymerisationsprodukt mit Strukturelementen der Formel I erhalten werden, zeichnen sich zudem durch eine erhöhte Hydrophilie aus, d.h. man kann die unbelichteten Stellen der Beschichtung auch mit wässrigen oder wässrig-alkalischen Entwickler-Lösungen auswaschen, was vom ökologischen Standpunkt aus im Vergleich zu gewissen organischen Entwicklungsbädern von Vorteil sein kann. Derartige Beschichtungen können auch mit kationischen Farbstoffen gefärbt werden.

Beispiele 1–5

0,25 g Polybutadien (36% cis-1,4, 54% trans-1,4, 10% 1,2-Vinyl, durchschnittliches Molekulargewicht $\bar{M}_w = 0{,}23 \times 10^6$; $\bar{M}_w/\bar{M}_n = 1{,}9$) werden jeweils mit den in der folgenden Tabelle I angegebenen Mengen N,N'-Octamethylen-bis-dimethylmaleinimid und 18 mg Thioxanthon in 7,19 g Toluol gelöst. Mit den erhaltenen Lösungen werden Kupfer-Leiterplatten mit Hilfe eines 50 µm Rakels beschichtet und 3 Minuten bei 100°C getrocknet. Die Beschichtung wird anschliessend durch eine photographische Maske mit einem Stufenkeil (21 Step Sensitivity Guide Stouffer) im Abstand von 70 cm mit einem 5000 W Hockdruckbrenner belichtet und während 1 Minute in Toluol entwickelt.

Tabelle I

| Beispiel Nr. | Imid Gew.% 1) | Verhältnis Doppelbindungen Polymer/Imid 2) | Belichtungszeit (Sek.) | letzte abgebildete Stufe |
|---|---|---|---|---|
| 1 | 50 | 6,7 | 10 | 8 |
| | | | 30 | 13 |
| 2 | 25 | 13,2 | 10 | 11 |
| | | | 30 | 14 |
| 3 | 11 | 29,8 | 10 | 12 |
| | | | 30 | 14 |
| 4 | 5 | 64,1 | 10 | 10 |
| | | | 30 | 13 |
| 5 | 2,5 | 130,0 | 10 | 8 |
| | | | 30 | 12 |

1) bezogen auf das Gewicht des Ausgangspolymeren

2) Verhältnis der Doppelbindungen im ungesättigten Ausgangspolymeren zu dem Bisimid.

Beispiel 6

5,0 g Polybutadien mit endständigen OH-Gruppen ($M_w$=2800, 64% 1,4-trans, 20% 1,4-cis, 20% Vinylkonfiguration) werden in 57 g Toluol gelöst. Die Lösung wird in ein Gefäss gegeben, das mit Tropftrichter, Rückflusskühler, Stickstoffein- und -auslass, Magnetrührer und einem 125 W HPK Philips-Hockdruckbrenner ausgestattet ist, und dann während 15 Minuten mit Stickstoff gespült. Unter Bestrahlung des Gefässinhaltes wird während 150 Minuten eine Lösung von 0,51 g Dimethylmaleinsäureanhydrid und 0,25 g Thioxanthon in 70 g Toluol zugetropft. Das Reaktionsgefäss wird weitere 16 Stunden bestrahlt, worauf man das erhaltene Polymere in einem 20-fachen Überschuss Diäthyläther ausfällt. Das Polymer wird anschliessend im Vakuum bei 20°C getrocknet, Ausbeute: 5,3 g. Tg = −56°C. Elementaranalyse: gefunden C 73,52% H 10,41% $\eta_{red.}$ = 0,08 dl/g (0,5%ige Lösung in m-Kresol bei 25°C). Gesamtsäuregehalt: 0,72 mÄquiv./g (entspricht einer ca. 4%igen Besetzung der C=C-Doppelbindungen des Polymeren). 5,0 g des so erhaltenen Polymeren, 50 mg N,N'-Hexamethylen-bis-dimethylmaleinimid und 27,5 mg 7-Methyl-thioxanthon-3-carbonsäureäthylester werden in 11 g Chloroform gelöst. Mit der Lösung wird mit einem 50 µm Rakel eine Kupfer-Leiterplatte beschichtet und 3 Minuten bei 80°C getrocknet. Dann wird die Beschichtung durch eine photographische Maske der in den Beispielen 1-5 beschriebenen Art 2 Minuten mit einem 5000 W Hockdruckbrenner im Abstand von 70 cm belichtet. Die nicht belichteten Teile der Beschichtung werden anschliessend während 5 Minuten in 5%iger NaOH ausgewaschen. Letzte abgebildete Stufe auf dem Stufenkeil: 8.

**Patentansprüche**

1. In Gegenwart von Sensibilisatoren unter Lichteinwirkung vernetzbare Stoffgemische, enthaltend

A) ein aliphatisch ungesättigtes Polymerisationsprodukt, das durch Homo- oder Copolymerisation von Dienen, wie Butadien, Isopren, Chloropren oder Gemischen davon, gegebenenfalls in Mischung mit anderen ethylenisch ungesättigten Monomeren, die frei von aromatischen Gruppen sind und gegebenenfalls Strukturelemente der Formel I

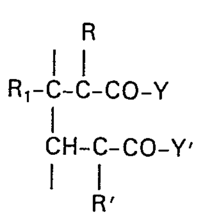

(I)

aufweist, und

B) ein Bisimid der Formel II

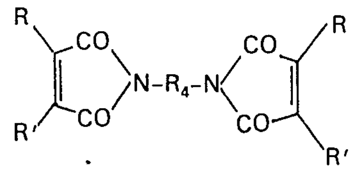

(II)

worin R und R' unabhängig voneinander $C_{1-4}$-Alkyl oder zusammen gegebenenfalls durch eine Methylgruppe substituiertes Tetramethylen oder eine Gruppierung der Formel III

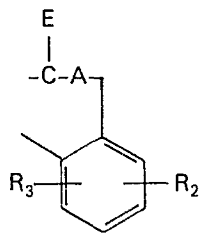

(III)

$R_1$ Wasserstoff, Chlor oder Methyl,

$R_2$ und $R_3$ unabhängig voneinander Wasserstoff, Halogen, $C_{1-4}$-Alkyl oder Methoxy,

A $-CH_2-$, $-CH_2CH_2-$ oder $-OCH_2-$ mit an den aromatischen Ring gebundenem Sauerstoff und

E Wasserstoff oder A -O- und E $-CH_3$,

$R_4$ $-C_mH_{2m}-$ mit m = 1 bis 20, $-(CH_2)_xQ(CH_2)_{x'}-$, $-(CH_2)_2NH(CH_2)_2\,NH(CH_2)_2-$, $-CH_2-Z-CH_2-$, Phenylen, das durch ein oder zwei Chloratome oder eine oder zwei Methylgruppen substituiert sein kann, Naphthylen, eine Gruppe

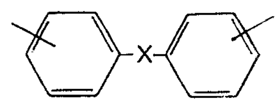

oder

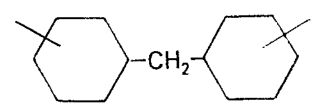

Q -S-, -O- oder -NH-,

x und x' unabhängig voneinander eine Zahl von 2 bis 4,

Z Phenylen oder $C_{4-6}$-Cycloalkylen,

X die direkte Bindung, -O-, -S-, $-SO_2-$, $-CH_2-$ oder $-C(CH_3)_2-$ und Y und Y' je -OH oder zusammen -O- darstellen, wobei der Anteil an Bisimid der Formel II 0,1 bis 75 Gew.%, bezogen auf das Polymer A), beträgt.

2. Stoffgemische nach Anspruch 1, worin der Anteil an Bisimid der Formel II 1 bis 25 Gew.%, bezogen auf das Polymer A) beträgt.

3. Stoffgemische nach Anspruch 1, worin R und R' zusammen eine Gruppierung der Formel III darstellen, worin E, $R_2$ und $R_3$ Wasserstoff sind und A $-CH_2-$ bedeutet.

4. Stoffgemische nach Anspruch 1, worin R und R' zusammen Tetramethylen, 3- oder 4-Tetramethylen und insbesondere je Methyl bedeuten.

5. Stoffgemische nach Anspruch 1, worin $R_4$ geradkettiges $-C_mH_{2m}-$ mit m = 2-10,

$-(CH_2)_2Q(CH_2)_2-$ mit Q = -S-, -O- und insbesondere -NH-, $-CH_2$-Z-$CH_2-$ mit Z = 1,3- oder 1,4-Phenylen oder 1,3- oder 1,4-Cyclohexylen; den Rest des 4,4′-Diaminodiphenylmethans, 4,4′-Diaminodiphenyläthers oder 4,4′-Diaminodiphenylsulfids, 1,3- oder 1,4-Phenylen bedeutet.

6. Stoffgemische nach Anspruch 1, worin R und R′ je Methyl, Y und Y′ zusammen -O- und $R_4$ $-(CH_2)_2NH(CH_2)_2-$ und vor allem geradkettiges $-C_mH_{2m}-$ mit m = 2–10 bedeuten.

7. Stoffgemische nach Anspruch 1, worin das Polymere aus wiederkehrenden Strukturelementen der Formel IV oder V

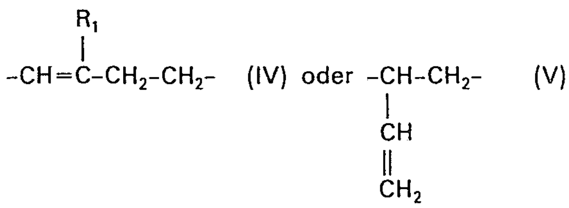

(IV) oder (V)

besteht, worin $R_1$ die im Anspruch 1 gegebene Bedeutung hat.

8. Stoffgemische nach Anspruch 1, worin das Polymere ein 1,2- und insbesondere ein 1,4-Polybutadien ist.

9. Stoffgemische nach Anspruch 1, worin der Sensibilisator ein unsubstituiertes oder substituiertes Thioxanthon ist.

10. Beschichtetes Material, enthaltend auf einem Substrat eine lichtempfindliche Schicht gemäss Anspruch 1.

11. Verwendung des Materials gemäss Anspruch 10 zur Herstellung von Druckplatten oder als Photoresistmaterialien.

## Claims

1. A composition of matter which crosslinks under the action of light in the presence of sensitisers and comprises

A) an aliphatically unsaturated polymerisation product which is obtained by homo- or copolymerisation of dienes such as butadiene, isoprene, chloroprene or mixtures thereof, optionally in admixture with other ethylenically unsaturated monomers which are free of aromatic groups, and which may contain structural units of the formula

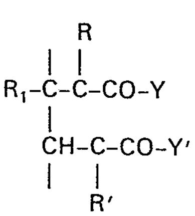

(I)

and

B) a bisimide of the formula II

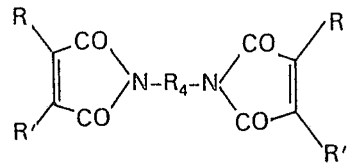

(II)

in which R and R′ are each independently of the other $C_{1-4}$ alkyl or together are tetramethylene which is unsubstituted or substituted by a methyl group, or a grouping of the formula III

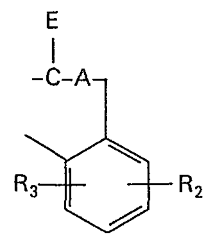

(III)

$R_1$ is hydrogen, chlorine or methyl, $R_2$ and $R_3$ are each independently of the other hydrogen, halogen, $C_{1-4}$ alkyl or methoxy, A is $-CH_2-$, $-CH_2CH_2-$ or $OCH_2-$ with oxygen bonded to the aromatic ring, and E is hydrogen, or A is -O- and E is $-CH_3$, $R_4$ is $-C_mH_{2m}-$, where m = 1 to 20, $-(CH_2)_xQ(CH_2)_{x'}-$, $-(CH_2)_2NH(CH_2)_2\ NH(CH_2)_2-$, $-CH_2$-Z-$CH_2$, phenylene which can be substituted by 1 or 2 chlorine atoms or 1 or 2 methyl groups, or is naphthalene or a group of formula

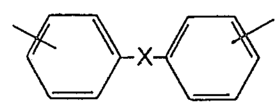

or

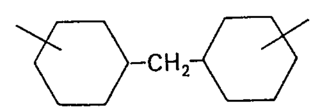

Q is -S-, -O- or -NH-, X and X′ are each independently of the other a number from 2 to 4, Z is phenylene or $C_{4-6}$ cylcoalkylene, X is a direct bond, -O-, -S-, $-SO_2-$, $-CH_2-$ or $C(CH_3)_2-$, and Y and Y′ are each -OH or together are -O-, and the amount of bisimide of formula II is 0.1 to 75% by weight, based on polymer A).

2. A composition of matter according to claim 1, wherein the amount of bisimide of the formula II is 1 to 25% by weight, based on polymer A).

3. A composition of matter according to claim 1, wherein R and R′ together are a grouping of the formula III, in which E, $R_2$ and $R_3$ are each hydrogen and A is $-CH_2-$.

4. A composition of matter according to claim 1, wherein R and R′ together are tetramethylene, 3- or 4-tetramethylene or, preferably, are each methyl.

5. A composition of matter according to claim 1, wherein $R_4$ is straight-chain $-C_mH_{2m}-$, where m = 2-10, $-(CH_2)_2Q(CH_2)_2-$, where Q = -S-, -O- or, preferably, -NH-, $-CH_2$-Z-$CH_2-$, where Z is 1,3- or 1,4-phenylene or 1,3- or 1,4-cyclohexylene, the

radical of 4,4′-diaminodiphenylmethane, 4,4′-diaminodiphenyl ether or 4,4′-diaminodiphenyl sulfide, or 1,3- or 1,4-phenylene.

6. A composition of matter according to claim 1, wherein R and R′ are each methyl, Y and Y′ together are -O- and $R_4$ is $-(CH_2)_2NH(CH_2)_2-$ or preferably straight chain $-C_mH_{2m}-$, where m = 2-10.

7. A composition of matter according to claim 1, wherein the polymer consits of recurring structural units of formula IV or V

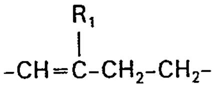 (IV) or 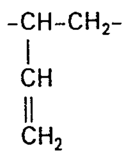 (V)

in which $R_1$ is as defined in claim 1.

8. A composition of matter according to claim 1, wherein the polymer is a 1,2- or, preferably, a 1,4-polybutadiene.

9. A composition of matter according to claim 1, wherein the sensitiser is an unsubstituted or substituted thioxanthone.

10. A coated material which contains on a substrate a light-sensitive layer according to claim 1.

11. Use of a material as claimed in claim 10 for the preparation of printing plates or as photoresist materials.

**Revendications**

1. Mélanges réticulables sous l'action de la lumière en présence de sensibilisateurs, mélanges qui contiennent:

A) un produit de polymérisation à insaturation aliphatique qui a été obtenu par homopolymérisation ou copolymérisation de diènes, tels que le butadiène, l'isoprène, le chloroprène ou des mélanges de ceux-ci, éventuellement en mélange avec d'autres monomères éthyléniques dépourvus de radicaux aromatiques, et contenant éventuellement des éléments structuraux de formule I:

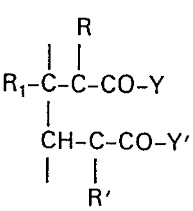 (I)

et

B) un bis-imide de formule II:

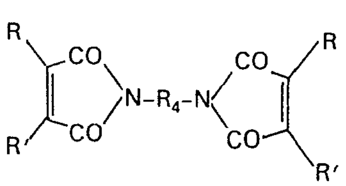 (II)

formules dans lesquelles:

R et R′ représentent chacun, indépendamment l'un de l'autre, un alkyle en $C_1$–$C_4$ ou forment ensemble un radical tétraméthylène éventuellement porteur d'un radical méthyle ou un groupement de formule III:

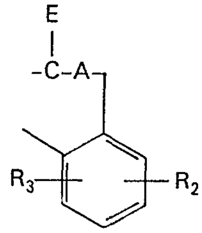 (III)

$R_1$ représente l'hydrogène, le chlore ou un méthyle,

$R_2$ et $R_3$ représentent chacun, indépendamment l'un de l'autre, l'hydrogène, un halogène, un alkyle en $C_1$–$C_4$ ou un méthoxy,

A représente $-CH_2-$, $-CH_2CH_2-$ ou un radical $-OCH_2-$ dont l'oxygène est lié au noyau aromatique, et E représente l'hydrogène, ou encore A représente -O- et E représente $-CH_3$,

$R_4$ représente un radical $-C_mH_{2m}-$ dont l'indice m est un nombre de 1 à 20, $-(CH_2)_xQ(CH_2)_{x'}-$, $-(CH_2)_2NH(CH_2)_2NH(CH_2)_2-$, $-CH_{221-Z-CH2}-$, un radical phénylène éventuellement porteur d'un ou de 2 atomes de chlore ou d'un ou de 2 radicaux méthyles, un radical naphtylène ou un radical

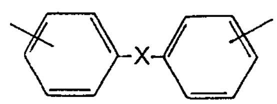 ou

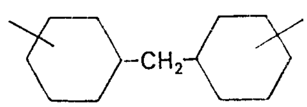

Q représente -S-, -O- ou, plus particulièrement, -NH-,

x et x′ représentent chacun, indépendamment l'un de l'autre, un nombre de 2 à 4,

Z représente un phénylène ou un cycloalkylène en $C_4$-$C_6$,

X représente une liaison directe, -O-, -S-, $-SO_2-$, $-CH_2-$ ou $-C(CH_3)_2-$ et

Y et Y′ représentent chacun un radical -OH ou forment ensemble un radical -O-,

la proportion du bis-imide de formule II étant comprise entre 0,1 et 75% en poids par rapport au polymère A).

2. Mélanges selon la revendication 1 dans lesquels la teneur en bis-imide de formule II est comprise entre 1 et 25% en poids par rapport au polymère A).

3. Mélanges selon la revendication 1 dans lesquels R et R′ forment ensemble un groupement de formule III dans lequel E, $R_2$ et $R_3$ représentent chacun l'hydrogène et A représente un radical $-CH_2-$.

4. Mélanges selon la revendication 1 dans lesquels R et R′ forment ensemble un radical tétraméthylène, méthyl-3 tétraméthylène ou méthyl-4 tétraméthylène, ou représentent plus particulièrement chacun un radical méthyle.

5. Mélanges selon la revendication 1 dans lesquels $R_4$ représente un radical $-C_mH_{2m}-$ linéaire dans lequel m désigne un nombre de 2 à 10, un radical $-(CH_2)_2Q(CH_2)_2-$ dans lequel Q représente -S-, -O- ou, mieux, -NH-, un radical $-CH_2-Z-CH_2-$ dans lequel Z représente un radical phénylène-1,3 ou -1,4 ou un radical cyclohexylène-1,3 ou -1,4; le radical du diamino-4,4′ diphénylméthane, de l'oxyde de bis-(amino-4 phényle) ou du sulfure de bis-(amino-4 phényle), un radical phénylène-1,3 ou un radical phénylène-1,4.

6. Mélanges selon la revendication 1 dans lesquels R et R′ représentent chacun un méthyle, Y et Y′ forment ensemble -O-, et $R_4$ représente un radical $-(CH_2)_2NH(CH_2)_2-$ ou mieux, un radical $-C_mH_{2m}-$ linéaire dans lequel m désigne un nombre de 2 à 10.

7. Mélanges selon la revendication 1 dans lesquels le polymère est constitué d'éléments structuraux répétés répondant à la formule IV ou à la formule V:

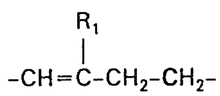 (IV) ou 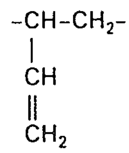 (V)

où $R_1$ a la signification qui lui a été donnée à la revendication 1.

8. Mélanges selon la revendication 1 dans lesquels le polymère est un polybutadiène 1,2 ou, plus particulièrement, un polybutadiène 1,4.

9. Mélanges selon la revendication 1 dans lesquels le sensibilisateur est une thioxanthone substituée ou non.

10. Matériau revêtu qui comporte, sur un substrat, une couche photosensible selon la revendication 1.

11. Application du matériau selon la revendication 10 à la fabrication de clichés d'imprimerie ou comme matériaux pour photoréserves.